# EUROPÄISCHE PATENTANMELDUNG

(11) **EP 2 276 075 A1**
(43) Veröffentlichungstag der Anmeldung: **19.01.2011**
(21) Anmeldenummer: 10177668.0
(22) Anmeldetag: 15.02.2001
(51) Int. Cl.: H01L 33/00

(54) **Strahlung emittierendes Halbleiterbauelement und Verfahren zu dessen Herstellung**

(30) Priorität: 15.02.2000 DE 10006738; 23.05.2000 DE 10025448
(62) Teilanmeldung aus: 01913666.2
(71) Anmelder: OSRAM Opto Semiconductors GmbH, 93055 Regensburg (DE)
(72) Erfinder: Eisert, Dominik, 93049 Regensburg (DE); Härle, Volker, 93164 Laaber (DE); Kühn, Frank, 81739 München (DE); Mundbrod-Vangerow, Manfred, 89335 Oxenbronn (DE); Strauß, Uwe, 93077 Bad Abbach (DE); Zehnder, Ulrich, 93191 Rettenbach (DE); Baur, Johannes, 93051 Regensburg (DE); Jacob, Ulrich, 93053 Regensburg (DE); Nirschl, Ernst, 93173 Wenzenbach (DE); Linder, Norbert, 93138 Lappersdorf (DE); Sedlmeier, Reinhard, 93073 Neutraubling (DE)
(74) Vertreter: Epping - Hermann - Fischer

(57) **Zusammenfassung**

Es wird ein strahlungsemittierendes Halbleiterbauelement mit einer Mehrschichtstruktur (4) angegeben, wobei die Mehrschichtstruktur (4) eine strahlungsemittierende, aktive Schicht (5) enthält, und einem strahlungsdurchlässigen Fenster (1), das eine erste Hauptfläche (2) und eine der ersten Hauptfläche gegenüberliegende zweite Hauptfläche (3) aufweist und das mit der ersten Hauptfläche (2) an die Mehrschichtstruktur (4) grenzt, wobei das Fenster (1) zur Bildung von schräg zur ersten Hauptfläche (2) verlaufenden Strahlungsauskoppelflächen zumindest eine Ausnehmung (8) aufweist. Die Mehrschichtstruktur (4) ist hierbei zumindst teilweise mit einer Kontaktfläche (6) versehen, die eine Mehrzahl von Öffnungen (14) aufweist.

## Beschreibung

Die Erfindung betrifft ein strahlungsemittierendes Halbleiterbauelement nach dem Oberbegriff der Patentansprüche 1,5,8 und 42 sowie ein Herstellungsverfahren hierfür nach dem Oberbegriff des Patentanspruches 34.

Insbesondere bezieht sich die Erfindung auf ein strahlungsemittierendes Halbleiterelement mit einer auf einem Siliziumcarbid-basiernden Aufwachssubstrat aufgebrachten Nitrid-basierenden aktiven Mehrschichtstruktur.

Strahlungsemittierende Halbleiterbauelemente der genannten Art weisen in der Regel eine Halbleitermehrschichtstruktur mit einer aktiven, der Strahlungserzeugung dienenden Schicht auf, die auf einen strahlungsdurchlässigen Träger aufgebracht ist. Die Strahlungsauskopplung erfolgt durch den Träger hindurch. Bei dieser Anordnung ist jedoch die Strahlungsausbeute durch Totalreflexion der erzeugten Strahlung an der Trägeroberfläche stark eingeschränkt.

Bei quader- oder würfelförmigen Trägern ist der Anteil der totalreflektierten, nicht auskoppelfähigen Strahlung aufgrund der orthogonalen Anordnung von Seitenflächen und Hauptflächen des Trägers besonders hoch. Eine Erhöhung der Strahlungsausbeute kann dadurch erzielt werden, daß Ausnehmungen in dem Träger gebildet sind, deren Seitenflächen vorzugsweise schräg zu den Hauptflächen des Trägers angeordnet sind.

Besonders vorteilhaft ist hierbei eine Formgebung, wie sie in der Patentanmeldung DE 100 067 38.7 angegeben ist. Der Inhalt dieser Patentanmeldung wird ausdrücklich zum Inhalt der vorliegenden Patentanmeldung gemacht.

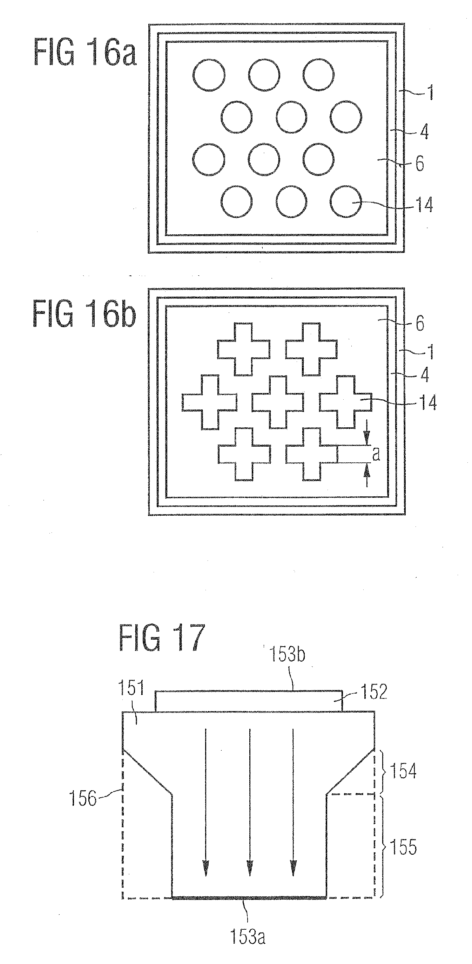

Ein entsprechendes Bauelement ist in Figur 17 schematisch dargestellt. Das gezeigte Halbleiterbauelement weist ein strahlungsdurchlässiges Fenster 151 auf, auf das eine strahlungserzeugende Mehrschichtstruktur 152 aufgebracht ist. Dabei ist mindestens eine Seitenfläche des Fensters 151 so gestaltet, daß ein erster Teilbereich 154 schräg, konkav oder stufenartig zur Normale der Mehrschichtstruktur 152 verläuft, an den sich ein zweiter, parallel zur Normale der Mehrschichtstruktur angeordneter Bereich 155 anschließt. Weiterhin sind auf der Mehrschichtstruktur 152 einerseits und auf der der Mehrschichtstruktur 152 abgewandten Seite des Halbleiterbauelementes andererseits zwei Kontaktflächen 153a,b ausgebildet.

Es ist Aufgabe der Erfindung, ein strahlungsemittierendes Halbleiterbauelement mit verbessertem Wirkungsgrad zu schaffen. Weiterhin ist es Aufgabe der Erfindung, ein Herstellungsverfahren hierfür zu entwickeln. Schließlich ist es Aufgabe der Erfindung, ein entspechendes optisches Bauelement zu entwickeln.

Diese Aufgabe wird durch ein strahlungsemittierendes Halbleiterbauelement nach Patentanspruch 1,5,8 bzw. 42 sowie ein Herstellungsverfahren nach Patentanspruch 34 gelöst. Vorteilhafte Weiterbildungen der Erfindung sind Gegenstand der abhängigen Ansprüche.

Die Erfindung geht davon aus, daß für den Wirkungsgrades das Verhältnis von auskoppelter Strahlungsleistung zu der hierfür aufzubringenden elektrischen Leistung maßgeblich ist. Die ausgekoppelte optische Leistung hängt neben dem durch das Bauelement fließenden Stom von dem Auskoppelgrad ab. Letzterer gibt an, wie groß der Anteil der ausgekoppelten Strahlung im Verhältnis zur insgesamt erzeugten Strahlung ist. Die elektrische Leistung wird von dem fließenden Strom und dem Serienwiderstand des Bauelements bestimmt. Eine Erhöhung des Wirkungsgrads kann daher insbesondere durch eine Erniedrigung des Serienwiderstands sowie eine Erhöhung des Auskoppelgrads erreicht werden.

Erfindungsgemäß ist in einer ersten Ausführungsform vorgesehen, ein strahlungsemittierendes Halbleiterbauelement mit einer Mehrschichtstruktur, einer aktiven, der Strahlungserzeugung dienenden Schicht innerhalb der Mehrschichtstruktur und einem strahlungsdurchlässigen Fenster mit einer ersten Hauptfläche und einer der ersten Hauptfläche gegenüberliegenden zweiten Hauptfläche zu bilden, wobei in dem Fenster mindestens eine Ausnehmung zur Bildung schräger Strahlungsauskoppelflächen geformt ist und mindestens eine Seitenfläche des Fensters und/oder der Ausnehmung mit einer Kontaktfläche versehen ist. Vorzugsweise erstreckt sich die Kontaktfläche auch über die zweite Hauptfläche des Fensters oder Teilbereiche hiervon.

Mit dieser Anordnung der Kontaktfläche wird der Strompfad von der Kontaktfläche zur aktiven Schicht im Mittel verkürzt und so vorteilhafterweise der Serienwiderstand des Bauelements reduziert.

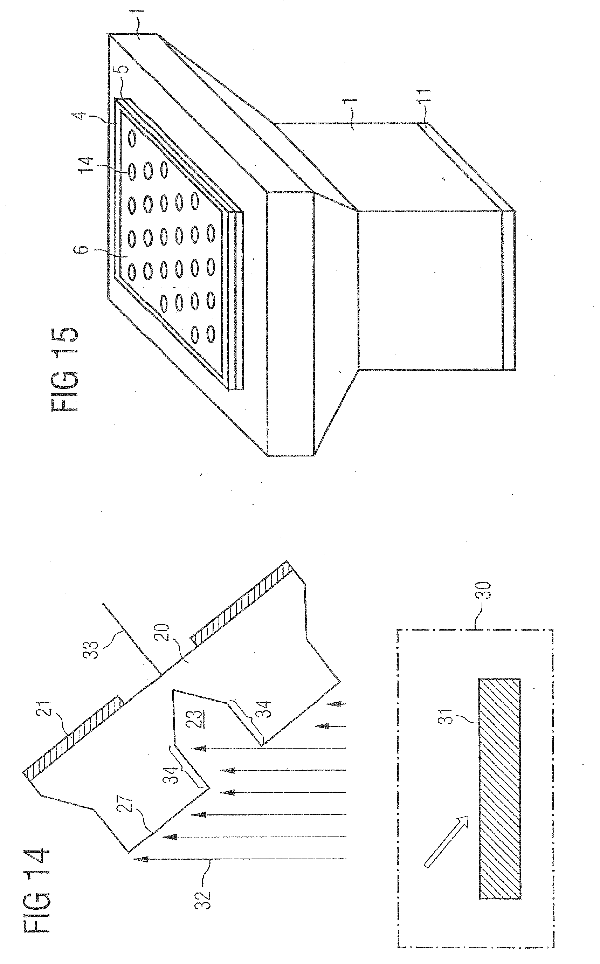

Die Ausnehmung dient bei der Erfindung der Erhöhung der Strahlungsausbeute. Insbesondere durch Seitenflächen, die zu den Fensterhauptflächen schräg stehen, wird dabei entweder eine unmittelbare Auskoppelung oder eine Reflexion in eine die Auskopplung begünstigende Richtung erzielt. Unter einer Ausnehmung in dem Fenster ist sowohl eine Vertiefung in der zweiten Hauptfläche des Fensters als auch eine randseitige Abtragung des Fensters, wie beispielsweise in Figur 15 dargestellt, zu verstehen. Bei einer randseitigen Abtragung fallen teilweise die Seitenflächen des Fensters und der Ausnehmung zusammen.

Vorzugsweise ist bei der Erfindung eine zweite Kontaktfläche auf der Mehrschichtstruktur vorgesehen. Dadurch wird eine Stromeinleitung nahe der aktiven Schicht innerhalb der Mehrschichtstruktur gewährleistet. Besonders vorteilhaft ist es hierbei, diese Kontaktfläche weitgehend strahlungsdurchlässig auszubilden, so daß eine Strahlungsauskopplung auch durch die zweite Kontaktfläche hindurch möglich ist. Dies kann beispielsweise durch entsprechend dünne Metallisierungen oder geeignet transparente, elektrisch leitfähige Schichten erreicht werden.

Bei einer bevorzugten Weiterbildung der Erfindung ist die erste Kontaktfläche spiegelnd ausgeführt. Dadurch werden die Strahlungsanteile, die aus dem Inneren des Fensters auf die Kontaktfläche auftreffen, nicht absorbiert, sondern zurück reflektiert, so daß eine nachfolgende Auskopplung möglich ist. Sowohl eine strahlungsdurchlässige wie eine spiegelnde Kontaktfläche tragen somit zur Erhöhung der Strahlungsausbeute bei, da sie entweder unmittelbar oder mittelbar die Auskopplung der Strahlung begünstigen.

Bei einer zweiten Ausführungsform der Erfindung ist vorgesehen, ein strahlungsemittierendes Halbleiterbauelement mit einer Mehrschichtstruktur, einer aktiven, der Strahlungserzeugung dienenden Schicht innerhalb der Mehrschichtstruktur und einem strahlungsdurchlässigen Fenster mit einer ersten Hauptfläche und einer der ersten Hauptfläche gegenüberliegenden zweiten Hauptfläche zu bilden, wobei in dem Fenster mindestens eine Ausnehmung zur Bildung schräger Strahlungsauskoppelflächen geformt ist. Dabei weist das Bauelement mindestens eine Kontaktfläche mit einer Mehrzahl von Öffnungen auf.

Bevorzugt ist dabei mindestens eine der Fensteroberflächen zumindest teilweise mit einer erste Kontaktfläche und die Mehrschichtstruktur zumindest teilweise mit einer zweiten Kontaktfläche versehen, wobei zumindest eine der Kontaktflächen eine Mehrzahl von Öffnungen aufweist. Vorteilhafterweise kann auch in beiden Kontaktflächen jeweils eine Mehrzahl von Öffnungen gebildet sein.

Diese, im folgenden als perforiert bezeichneten Kontaktflächen weisen gegenüber dünnen, strahlungsdurchlässigen Kontaktflächen den Vorteil einer höheren Langzeitstabilität, insbesondere in einer Vergußmasse wie beispielsweise Epoxidharz, auf. Ferner können diese perforierten Kontaktflächen so gebildet werden, daß sie im Bereich der Öffnungen eine hohe Transmission und in den mit Kontaktmaterial belegten Bereichen eine hohe Reflexion aufweisen, so daß an diesen Kontaktflächen die Absorption und damit der Strahlungsverlust vorteilhaft gering ist.

Perforierte Kontaktflächen auf der Mehrschichtstruktur weisen zusätzlich den Vorteil auf, daß sie die Mehrschichtstruktur nicht versiegeln, so daß beispielsweise Gase wie Wasserstoff, die bei der Herstellung in die Mehrschichtstruktur gelangen, aus dieser herausdiffundieren können. Dadurch wird auch die Gefahr verringert, daß solche Gase an der Grenzfläche zwischen Mehrschichtstruktur und Kontaktfläche aggregieren, die Kontaktfläche passivieren und so den Kontakt- bzw. Serienwiderstand erhöhen.

Vorzugsweise sind die Öffnungen in der bzw. den Kontaktflächen kreisförmig, quadratisch, rechteckig, sechseckig oder kereuzschlitzförmig gebildet. Diese Formen eignen sich insbesondere für eine regelmäßige Anordnung und sich technisch vergleichsweise einfach herstellbar. Vorzugsweise sind die Öffnungen dicht gepackt angordnet mit der Maßgabe, daß die dazwischenliegenden Bereiche der Kontaktfläche ein zusammenhängendes Netz bilden und die Breite der Bereiche den Anforderungen zur Stomeinleitung in das Bauelement genügt. Selbstverständlich sind die genannten Formgebungen nicht als Beschränkung der Erfindung hierauf zu verstehen.

Bei einer vorteilhaften Ausgestaltung der Erfindung in beiden Ausführungsformen ist die Ausnehmung in Form einer Vertiefung in der zweiten Hauptfläche des Fensters gebildet. Mit Vorteil ist dabei keine Änderung der einhüllenden Fenstergrundform erforderlich, so daß insbesondere Produktionsanlage, die oftmals für eine bestimmte Fenstergrundform ausgelegt sind, unverändert weiterverwendet werden können. Weiterhin kann auch eine Mehrzahl von Vertiefungen in der zweiten Hauptfläche ausgebildet sein, wodurch die Strahlungsausbeute weiter erhöht wird. Diese Gestaltung ist insbesondere von Vorteil für großflächige Halbleiterbauelemente, da mit steigender Chipfläche das Verhältnis von Fläche zu Umfang steigt und somit mehr Vertiefungen in der Fläche als umfangseitig angeordnet werden können.

Bei einer bevorzugten Weiterbildung der Erfindung ist die Vertiefung in der zweiten Hauptfläche mit einem dreieckigen, trapezförmigen oder halbkreisförmigen Querschnitt (Schnitt senkrecht zur 2. Hauptfläche) ausgebildet. Weitergehend kann der Querschnitt auch die Form eines Rechtecks mit einem angesetzten Dreieck, Trapez oder Halbkreis aufweisen. Allgemein ist die Ausbildung von Ausnehmungen mit mindestens einer nicht orthogonal zu den Hauptflächen angeordneten Seitenfläche vorteilhaft.

Je nach konkreter Ausführungsform wird dadurch der Einfallswinkel der erzeugten Strahlung zur Seitenflächennormale und damit der Anteil der total reflektierten Strahlung erniedrigt oder eine Reflexion in Richtung der Fensterflanken bewirkt, so daß eine unmittelbare Auskopplung oder zumindest eine Auskopplung nach weiteren Reflexionen stattfinden kann. Letzteres trifft insbesondere für Seitenflächen der Vertiefung zu, die mit einer spiegelnden Kontaktfläche versehen sind.

Vorzugsweise ist die Vertiefung in der zweiten Hauptfläche des Fensters in Form eines Grabens mit einer der oben genannten Querschnittsformen ausgebildet. Eine solche Vertiefung ist beispielsweise durch Einsägen des Fensters von der zweiten Hauptfläche aus unter Verwendung eines Sägeblattes mit Formrand herstellbar. Erfolgt dieses Einsägen im Waferverbund, so können vorteilhafterweise in einem Herstellungsschritt eine Vielzahl von Fenstern strukturiert werden.

Alternativ können die Vertiefungen auch eingeätzt werden. Bei dieser Ausführungsform können insbesondere auch räumlich isolierte, allseitig berandete Vertiefungsformen gebildet werden. Mit Vorteil ist auch hier im Waferverbund die Strukturierung einer Vielzahl von Fenstern in einem Herstellungsschritt möglich.

Bei einer besonders bevorzugten Weiterbildung der Erfindung ist die die Strahlungsausbeute erhöhende Ausnehmung am Rand der zweiten Hauptfläche gebildet und so geformt, daß sich das Fenster zur zweiten Hauptfläche hin verjüngt. Bevorzugt ist die Ausnehmung so gebildet, daß die Seitenflächen der Ausnehmung in der Nähe der Mehrschichtstruktur einen zur Normale der Mehrschichtstruktur schräg stehenden ersten Teilbereich aufweisen, der in größerer Entfernung zur Mehrschichtstruktur in einen parallel zur Normalen der Mehrschichtstruktur verlaufenden zweiten Teilbereich übergeht.

Vorzugsweise ist das Fenster in dem den zweiten Bereich entsprechenden Abschnitt quaderförmig gebildet. Vorteilhafterweise wird durch den angeschrägten Teilbereich die Strahlungsausbeute erhöht, während der verbleibende Fensterbereich eine quaderförmige Grundform aufweist und so leicht zu montieren ist. Hierbei sind insbesondere die Seitenflächen den zweiten Teilbereiches mit einer Kontaktfläche versehen. Die Kontaktfläche kann sich auch über den ersten Teilbereich der Seitenflächen erstrecken und ist dann vorzugsweise spiegelnd ausgebildet, so daß durch Reflexion der erzeugten Strahlung in Richtung der Mehrschichtstruktur die Strahlungsausbeute erhöht wird.

Mit Vorteil kann die beschriebene Struktur mit geringem Herstellungsaufwand geformt werden, indem beispielsweise ein Wafer zur Vereinzelung der Halbleiterkörper mit einem Sägeblatt mit Formrand eingesägt und nachfolgend die Halbleiterkörper durch Brechen des Wafers vereinzelt werden. Um die Vereinzelung durch Brechen zu erleichtern, ist ein vorheriges Einsägen des Wafers zweckmäßig. Bei Verwendung eines geeigneten Sägeblatts mit Formrand kann dabei zugleich die beschriebene Fensterform herausgebildet werden. Weitere vorteilhafte Ausgestaltungen hierzu sind in DE 100 067 38.7 angegeben, auf die sich die vorliegende Erfindung insbesondere bezieht.

Ein erfindungsgemäßes Herstellungsverfahren beginnt mit der Bereitstellung einer Fensterschicht, aus der später das eigentliche Fenster gefertigt wird.

Auf die Fensterschicht wird eine der Mehrschichtstruktur entsprechende Halbleiterschichtenfolge aufgebracht. Die Aufbringung erfolgt vorzugsweise epitaktisch oder im Rahmen eines Waverbonding-Verfahrens. Bei der Epitaxie stellt die Fensterschicht vorteilhafterweise zugleich das Epitaxiesubstrat dar. Bei einem Waferbonding-Verfahren wird die Halbleiterschichtenfolge zunächst auf einem geeigneten Substrat hergestellt und nachfolgend auf die Fensterschicht gebondet. Mit Vorteil können hier als Fenstermaterial auch Materialien eingesetzt werden, die nicht für ein Epitaxieverfahren geeignet sind.

In einem weiteren Schritt wird die Fensterschicht zur Ausbildung der Ausnehmung in geeigneter Weise strukturiert. Die Strukturierung kann beispielsweise wie beschrieben durch Einsägen oder Ätzen der Fensterschicht erfolgen. Die Strukturierung kann auch in mehreren, nicht notwendigerweise aufeinanderfolgenden Schritten durchgeführt werden. So ist es hinsichtlich der mechanischen Bruchstabilität der Fensterschicht vorteilhaft, die Fensterschicht zunächst vorzustrukturieren und erst in einem späteren Stadium des Herstellungsverfahrens die endgültige Strukturierung vorzunehmen.

In einem weiteren Schritt werden die Kontaktflächen auf die Fensterschicht aufgebracht. Die Kontaktflächen werden vorzugsweise als Kontaktmetallisierung aufgedampft oder aufgestäubt.

Abschließend werden die Halbleiterbauelemente fertiggestellt. Dies umfaßt insbesondere die Vereinzelung des Verbunds aus Fensterschicht und Halbleiterschichtenfolge in eine Mehrzahl von Fenstern mit darauf befindlicher Mehrschichtstruktur. Die Vereinzelung erfolgt vorzugsweise durch Einsägen und/oder Brechen der Fensterschicht. Im Rahmen der Fertigstellung können auch noch zusätzliche Kontaktflächen wie beispielsweise Kontaktmetallisierungen auf der Mehrschichtstruktur aufgebracht werden.

Zur Ausbildung der Kontaktmetallisierung werden üblicherweise Bedampfungsanlagen verwendet, aus denen der Metalldampf mit einer gewissen Vorzugsrichtung austritt. Hierbei ist es vorteilhaft, die zu bedampfende Fläche der Fensterschicht schräg zu dieser Vorzugsrichtung anzuordnen. Damit wird ein Niederschlag des Metalldampfes auf der zweiten Hauptfläche der Fensterschicht wie auch auf den durch die Strukturierung gebildeten Seitenflächen der Ausnehmungen erreicht.

Hinsichtlich der Abfolge der beschriebenen Herstellungsschritte zeichnen sich drei nachfolgend beschriebene Alternativen durch besondere Vorteile aus:
Bei der ersten vorteilhaften Alternative wird auf die Fensterschicht zunächst die Halbleiterschichtenfolge aufgebracht, nachfolgend die Fensterschicht strukturiert und abschließend zur Ausbildung der Kontaktflächen bedampft. Insbesondere bei der epitaktischen Herstellung der Halbleiterschichtenfolge können hierzu bestehende Fertigungsvorrichtungen unverändert verwendet werden, da sich bei der Epitaxie die Fensterschicht noch nicht von Fensterschichten nach dem Stand der Technik unterscheidet. Zudem wird die Fensterschicht erst am Ende des Herstellungsverfahrens strukturiert, so daß die Gefahr eines Bruches der Fensterschicht bei den vorangehenden Schritten vergleichsweise gering ist.

Eine zweite vorteilhafte Alternative stellt ein Verfahren dar, bei dem die Fensterschicht zunächst strukturiert und mit Kontaktflächen versehen wird. Nachfolgend wird die Halbleiterschichtenfolge aufgebracht. Hierbei können zur Ausbildung der Kontaktmetallisierung höhere Temperaturen, wie sie zur Sinterung bestimmter Kontaktmetallisierungen nötig sind, angewendet werden. Diese Temperaturen sind in der Regel so hoch, daß die Halbleiterschichtenfolge dabei beschädigt würde. Durch die Ausbildung der Kontaktmetallisierung am Beginn des Herstellungsverfahrens wird daher eine solche Beschädigung vermieden.

Bei einer dritten vorteilhaften Alternative des Herstellungsverfahrens findet die Strukturierung der Fensterschicht in zwei Schritten statt. Dazu wird zunächst die Fensterschicht soweit vorstrukturiert, wie es für die Ausbildung der Kontaktflächen auf den Seitenflächen erforderlich ist. Nachfolgend werden die Kontaktflächen, beispielsweise durch Bedampfen, ausgebildet. Auf die so vorstrukturierte und mit Kontaktflächen versehene Fensterschicht wird nun die Halbleiterschichtenfolge aufgebracht. Abschließend erfolgt die Endstrukturierung der Fensterschicht. Vorzugsweise wird dieser zweite Strukturierungsschritt mit einer Vereinzelung der Bauelemente verbunden, indem beispielsweise die Fensterschicht mit einem Formsägeblatt eingesägt und dann durch Brechen zerteilt wird. Um die Bruchgefahr der strukturierten Fensterschicht zum mindern, kann die Fensterschicht auch auf einen geeigneten Hilfsträger montiert werden.

Weiterhin werden die folgenden Aspekte der Erfindung in einer nummerierten Reihenfolge als Teil der Beschreibung angegeben:
1. Strahlungsemittierendes Halbleiterbauelement mit einer Mehrschichtstruktur, die eine strahlungsemittierende, aktive Schicht enthält, und einem strahlungsdurchlässigen Fenster, das eine erste Hauptfläche und eine der ersten Hauptfläche gegenüberliegende zweite Hauptfläche aufweist und das mit der ersten Hauptfläche an die Mehrschichtstruktur grenzt, wobei das Fenster zur Bildung von schräg zur ersten Hauptfläche verlaufenden Strahlungsauskoppelflächen zumindest eine Ausnehmung aufweist, wobei
   mindestens eine an die zweite Hauptfläche grenzende Seitenfläche des Fensters und/oder der Ausnehmung zumindest teilweise mit einer ersten Kontaktfläche versehen ist.
2. Strahlungsemittierendes Halbleiterbauelement nach Aspekt 1, wobei die erste Kontaktfläche auch die zweite Hauptfläche des Fensters zumindest teilweise bedeckt.
3. Strahlungsemittierendes Halbleiterbauelement nach Aspekt 1 oder 2, wobei auf der Mehrschichtstruktur eine zweite Kontaktfläche ausgebildet ist.
4. Strahlungsemittierendes Halbleiterbauelement nach einem der Aspekte 1 bis 3, wobei zumindest eine der Kontaktflächen eine Mehrzahl von Öffnungen aufweist.
5. Strahlungsemittierendes Halbleiterbauelement mit einer Mehrschichtstruktur, die eine strahlungsemittierende, aktive Schicht enthält, und einem strahlungsdurchlässigen Fenster, das eine erste Hauptfläche und eine der ersten Hauptfläche gegenüberliegende zweite Hauptfläche aufweist und das mit der ersten Hauptfläche an die Mehrschichtstruktur grenzt, wobei das Fenster zur Bildung von schräg zur ersten Hauptfläche verlaufenden Strahlungsauskoppelflächen zumindest eine Ausnehmung aufweist, wobei die Mehrschichtstruktur zumindst teilweise mit einer Kontaktfläche versehen ist, die eine Mehrzahl von Öffnungen aufweist.
6. Strahlungsemittierendes Halbleiterbauelement nach Aspekt 5, wobei die zweite Hauptfläche und/oder mindestens eine an die zweite Hauptfläche grenzende Seitenfläche des Fensters und/oder der Ausnehmung zumindest teilweise mit einer weiteren Kontaktfläche versehen ist.
7. Strahlungsemittierendes Halbleiterbauelement nach Aspekt 6, wobei die weitere Kontaktfläche eine Mehrzahl von Öffnungen aufweist.
8. Strahlungsemittierendes Halbleiterbauelement mit einer Mehrschichtstruktur, die eine strahlungsemittierende, aktive Schicht enthält, und einem strahlungsdurchlässigen Fenster, das eine erste Hauptfläche und eine der ersten Hauptfläche gegenüberliegende zweite Hauptfläche aufweist und das mit der ersten Hauptfläche an die Mehrschichtstruktur grenzt, wobei das Fenster zur Bildung von schräg zur ersten Hauptfläche verlaufenden Strahlungsauskoppelflächen zumindest eine Ausnehmung aufweist, wobei die zweite Hauptfläche zumindest teilweise mit einer Kontaktfläche versehen ist, die eine Mehrzahl von Öffnungen aufweist.
9. Strahlungsemittierendes Halbleiterbauelement nach Aspekt 8, wobei die Kontaktfläche auch mindestens eine an die zweite Hauptfläche grenzende Seitenfläche des Fensters und/oder der Ausnehmung zumindest teilweise bedeckt.
10. Strahlungsemittierendes Halbleiterbauelement nach Aspekt 8 oder 9, wobei die Mehrschichtstruktur zumindest teilweise mit einer weitere Kontaktfläche versehen ist.
11. Strahlungsemittierendes Halbleiterbauelement nach Aspekt 10, wobei die weitere Kontaktfläche eine Mehrzahl von Öffnungen aufweist.
12. Strahlungsemittierendes Halbleiterbauelement nach einem der Aspekte 4 bis 11, wobei zumindest eine Teil der Öffnungen kreisförmig, quadratisch, rechteckig, sechseckig oder kreuzschlitzförmig gebildet sind.
13. Strahlungsemittierendes Halbleiterbauelement nach einem der Aspekte 4 bis 12, wobei die Öffnungen zumindest in Teilbereichen der Kontaktflächen regelmäßig angeordnet sind.
14. Strahlungsemittierendes Halbleiterbauelement nach einem der Aspekte 4 bis 13, wobei die Öffnungen kreuzschlitzförmig gebildet und zumindest in Teilbereichen der Kontaktflächen mit maximaler Packungsdichte angeordnet sind, wobei der Abstand zwischen den Öffnungen die Stegbreite der Kreuzschlitze nicht unterschreitet.
15. Strahlungsemittierendes Halbleiterbauelement nach einem der Aspekte 1 bis 14, wobei die Ausnehmung in Form einer Vertiefung der zweiten Hauptfläche gebildet ist.
16. Strahlungsemittierendes Halbleiterbauelement nach Aspekt 15, wobei die Vertiefung einen dreieckigen, trapezförmigen oder halbkreisförmigen Querschnitt aufweist.
17. Strahlungsemittierendes Halbleiterbauelement nach Aspekt 15, wobei die Vertiefung in Form eines Grabens mit dreieckigem, trapezförmigem oder halbkreisförmigem Querschnitt gebildet ist.
18. Strahlungsemittierendes Halbleiterbauelement nach einem der Aspekte 1 bis 17, wobei die zweite Hauptfläche des Fensters eine Mehrzahl von Vertiefungen aufweist.
19. Strahlungsemittierendes Halbleiterbauelement nach einem der Aspekte 1 bis 18, wobei die Ausnehmung randnahe gebildet ist, so daß sich das Fenster zur zweiten Hauptfläche hin verjüngt.
20. Strahlungsemittierendes Halbleiterbauelement nach Aspekt 19, wobei die Ausnehmung zumindest eine Seitenfläche aufweist, die einen ersten, schräg zur ersten Hauptfläche des Fensters Seitenflächenteil enthält, der sich in einem zweiten, senkrecht zur ersten Hauptfläche des Fensters Seitenflächenteil fortsetzt.
21. Halbleiterbauelement nach Aspekt 20, wobei alle Seitenflächen der Ausnehmung einen ersten Seitenflächenteil und eine zweiten Seitenflächenteil aufweisen.
22. Halbleiterbauelement nach Aspekte 20 oder 21, wobei der erste Seitenflächenteil eine ebene schrägstehende Fläche ist, die mit der Normale der Mehrschichtstruktur einen Winkel einschließt, der zwischen einschließlich 20° und einschließlich 30° liegt.
23. Halbleiterbauelement nach einem der Aspekte 20 bis 22, wobei mindestens der erste Seitenwandteil aufgerauht ist.
24. Strahlungsemittierendes Halbleiterbauelement nach einem der Aspekte 1 bis 23, wobei mindestens eine der Kontaktflächen als spiegelnde Kontaktmetallisierung ausgebildet ist.
25. Strahlungsemittierendes Halbleiterbauelement nach einem der Aspekte 1 bis 24, wobei mindestens eine der Kontaktflächen strahlungsdurchlässig ausgebildet ist.
26. Strahlungsemittierendes Halbleiterbauelement nach einem der Aspekte 1 bis 25, wobei zumindest eine der Kontaktflächen Platin, Palladium, Silber, Gold, Nickel oder eine Legierungen dieser Metalle enthält.
27. Strahlungsemittierendes Halbleiterbauelement nach einem der Aspekte 1 bis 26, wobei zumindest eine der Kontaktflächen eine Dicke zwischen 5nm und 200nm, vorzugsweise zwischen 10nm und 100nm aufweist.
28. Strahlungsemittierendes Halbleiterbauelement nach einem der Aspekte 1 bis 27, wobei das Fenster aus dem für das Aufwachsen der Mehrschichtstruktur genutzten Aufwachssubstrat gefertigt ist.
29. Strahlungsemittierendes Halbleiterbauelement nach einem der Aspekte 1 bis 28, wobei der Brechungsindex des Materials des Fensters größer als der Brechungsindex des Materials der Mehrschichtstruktur, insbesondere der aktiven Schicht ist.
30. Strahlungsemittierendes Halbleiterbauelement nach einem der Aspekte 1 bis 29, wobei das Fenster Saphir, Quarzglas, Diamant, ITO, Zinnoxyd, Zinkoxyd, Indiumoxyd, Siliciumcarbid oder Galliumphosphid enthält.
31. Strahlungsemittierendes Halbleiterbauelement nach einem der Aspekte 1 bis 30, wobei die Mehrschichtfolge aus Nitrid-basierenden Halbleitermaterialien gefertigt ist.
32. Strahlungsemittierendes Halbleiterbauelement nach einem der Aspekte 1 bis 31, wobei die Mehrschichtstruktur auf Galliumnitrid-basierenden Halbleitermaterialien gefertigt ist und vorzugsweise mindestens eine der Verbindungen Al₁₋ₓGaₓN, 0 ≤x≤1, In₁₋ₓGaₓN, 0≤x≤1, In₁₋ₓAlₓN, 0≤x≤1 und Al_{1-x-y}InₓGa_{y}N, 0≤x≤1, 0≤y≤1 enthält.
33. Strahlungsemittierendes Halbleiterbauelement nach einem Aspekte 1 bis 32, wobei das Fenster aus Siliciumcarbid besteht oder auf Siliciumcarbid basiert und die Mehrschichtfolge aus Nitrid-basierenden Halbleitermaterialien gefertigt ist.
34. Verfahren zur Herstellung eines strahlungsemittierendes Halbleiterbauelements mit einer Mehrschichtstruktur, die eine strahlungsemittierende, aktive Schicht enthält, und einem strahlungsdurchlässigen Fenster, das eine erste Hauptfläche und eine der ersten Hauptfläche gegenüberliegende zweite Hauptfläche aufweist und das mit der ersten Hauptfläche an die Mehrschichtstruktur grenzt, wobei in dem Fenster zumindest eine Ausnehmung gebildet ist und mindestens eine Seitenfläche des Fensters und/oder der Ausnehmung zumindest teilweise mit einer ersten Kontaktfläche versehen ist, gekennzeichnet durch die Schritte
   - Bereitstellen einer Fensterschicht mit einer ersten Hauptfläche und einer der ersten Hauptfläche gegenüberliegenden zweiten Hauptfläche
   - Aufbringen einer Halbleiterschichtenfolge auf die erste Hauptfläche der Fensterschicht
   - Strukturierung der Fensterschicht, wobei mindestens eine Ausnehmung in der zweiten Hauptfläche gebildet wird
   - Ausbildung einer Kontaktfläche auf der Seite der zweiten Hauptfläche der Fensterschicht 20,
   - Fertigstellung der Halbleiterbauelemente.
35. Verfahren nach Aspekt 34, wobei die Kontaktfläche als Kontaktmetallisierung aufgedampft wird.
36. Verfahren nach Aspekt 35, wobei zur Bedampfung eine Bedampfungsquelle mit einer Vorzugsrichtung verwendet wird und die zu bedampfende Fensterschicht schräg zu dieser Vorzugsrichtung angeordnet ist.
37. Verfahren nach einem der Aspekte 34 bis 36, wobei die Halbleiterschichtenfolge epitaktisch auf die Fensterschicht aufgebracht wird.
38. Verfahren nach einem der Aspekte 34 bis 37, wobei die Halbleiterschichtenfolge mittels eines Waverbonding-Verfahrens auf die Fensterschicht aufgebracht wird.
39. Verfahren nach einem der Aspekte 34 bis 38, wobei die Verfahrensschritte in der Reihenfolge
   1. Aufbringen einer Halbleiterschichtenfolge,
   2. Strukturierung der zweiten Hauptfläche,
   3. Ausbildung der Kontaktfläche
   durchgeführt werden.
40. Verfahren nach einem der Aspekte 34 bis 38, wobei die Verfahrensschritte in der Reihenfolge
   1. Strukturierung der zweiten Hauptfläche,
   2. Ausbilden der Kontaktfläche,
   3. Aufbringen der Halbleiterschichtenfolge durchgeführt werden.
41. Verfahren nach einem der Aspekte 34 bis 38, wobei die Verfahrensschritte in der Reihenfolge
   1. Vorstrukturierung der zweiten Hauptfläche,
   2. Ausbilden der Kontaktfläche,
   3. Aufbringen der Halbleiterschichtenfolge,
   4. Endstrukturierung der zweiten Hauptfläche durchgeführt werden.
42. Strahlungsemittierendes Halbleiterbauelement mit einer Mehrschichtstruktur, die eine strahlungsemittierende aktive Schicht enthält, und einem strahlungsdurchlässigen Fenster, das ausschließlich an der von einer Hauptabstrahlrichtung des Halbleiterbauelements abgewandten Seite der Mehrschichtstruktur angeordnet ist und mindestens eine Seitenwand aufweist, die einen schräg, konkav oder stufenartig zu einer senkrecht zur Mehrschichtstruktur stehenden Mittelachse des Halbleiterkörpers hin verlaufenden ersten Seitenwandteil aufweist, der gesehen von der Mehrschichtstruktur im weiteren Verlauf zur Rückseite hin in einen senkrecht zur Mehrschichtstruktur, das heißt parallel zur Mittelachse verlaufenden zweiten Seitenwandteil übergeht, wobei der den zweiten Seitenwandteil umfassende Teil der Fensters einen Montagesockel für das Halbleiterbauelement bildet, wobei die Mehrschichtstruktur zumindest teilweise mit einer Kontaktfläche versehen ist, die eine Mehrzahl von Öffnungen aufweist.
43. Strahlungsemittierendes Halbleiterbauelement nach Aspekt 42, wobei das Fenster aus dem für das Aufwachsen der Mehrschichtstruktur genutzten Aufwachssubstrat gefertigt ist.
44. Strahlungsemittierendes Halbleiterbauelement nach Aspekt 42 oder 43, wobei der Brechungsindex des Materials des Fensters größer als der Brechungsindex des Materials der Mehrschichtstruktur, insbesondere der aktiven Schicht ist.
45. Strahlungsemittierendes Halbleiterbauelement nach einem der Aspekte 42 bis 44, wobei das Fenster aus Siliciumcarbid besteht oder auf Siliciumcarbid basiert und die Mehrschichtfolge aus Nitrid-basierenden Halbleitermaterialien gefertigt ist.
46. Strahlungsemittierendes Halbleiterbauelement nach Aspekt 45, wobei die Mehrschichtfolge aus einem Galliumnitrid-basierenden gefertigt ist.
47. Strahlungsemittierendes Halbleiterbauelement nach Aspekt 46, wobei die Mehrschichtenfolge mindestens eine der Verbindungen Al₁₋ₓGaₓN, 0≤x≤1, In₁₋ₓGaₓN, 0≤x≤1, In₁₋ₓAlₓN, 0≤x≤1 und Al_{1-x-y}InₓGa_{y}N, 0≤x≤1, 0≤y≤1 enthält.
48. Strahlungsemittierendes Halbleiterbauelement nach einem der Aspekte 42 bis 47, wobei alle Seitenflanken des Fensters einen ersten Seitenwandteil und eine zweiten Seitenwandteil aufweisen.
49. Strahlungsemittierendes Halbleiterbauelement nach nach einem der Aspekte 42 bis 48, wobei der erste Seitenwandteil eine ebene schrägstehende Fläche ist, die mit der Mittelachse einen Winkel einschließt, der zwischen einschließlich 20° und einschließlich 30° liegt.
50. Strahlungsemittierendes Halbleiterbauelement nach einem der Aspekte 45 bis 49, wobei das Halbleiterbauelement einen quadratischen lateralen Querschnitt aufweist, alle vier Seitenflanken des Fensters einen ebenen schrägstehenden ersten Seitenwandteil aufweisen, wobei das Verhältnis von Kantenlänge der Mehrschichtstruktur zu Kantenlänge des Montagesockels zwischen einschließlich 1,5 und einschließlich 2, besonders bevorzugt bei etwa 1,35 liegt.
51. Strahlungsemittierendes Halbleiterbauelement nach einem der Aspekte 42 bis 50, wobei mindestens der erste Seitenwandteil aufgerauht ist.
52. Strahlungsemittierendes Halbleiterbauelement nach einem der Aspekte 42 bis 51, wobei die Öffnungen kreisförmig, quadratisch, rechteckig, sechseckig oder kreuzschlitzförmig gebildet sind.
53. Strahlungsemittierendes Halbleiterbauelement nach einem der Aspekte 42 bis 52, wobei die Öffnungen zumindest in Teilbereichen der Kontaktflächen regelmäßig angeordnet sind.
54. Strahlungsemittierendes Halbleiterbauelement nach einem der Aspekte 42 bis 53, wobei die Öffnungen kreuzschlitzförmig gebildet und zumindest in Teilbereichen der Kontaktflächen mit maximaler Packungsdichte angeordnet sind, wobei der Abstand zwischen den Öffnungen die Stegbreite der Kreuzschlitze nicht unterschreitet.
55. Strahlungsemittierendes Halbleiterbauelement nach einem der Aspekte 42 bis 54, wobei die Kontaktfläche als spiegelnde Kontaktmetallisierung ausgebildet ist.
56. Strahlungsemittierendes Halbleiterbauelement nach einem der Aspekte 42 bis 55, wobei die Kontaktfläche strahlungsdurchlässig ausgebildet ist.
57. Strahlungsemittierendes Halbleiterbauelement nach einem der Aspekte 42 bis 56, wobei die Kontaktflächen Silber, Gold, Nickel, bevorzugt Platin oder Palladium, oder eine Legierungen dieser Metalle enthält.
58. Strahlungsemittierendes Halbleiterbauelement nach einem der Aspekte 42 bis 57, wobei die Kontaktflächen eine Dicke zwischen 5nm und 200nm, vorzugsweise zwischen 10nm und 100nm aufweist.
59. Strahlungsemittierendes optisches Bauelement mit einem strahlungsemittierenden Halbleiterbauelement nach einem der Aspekte 42 bis 58, wobei das optische Bauelement eine Reflektorwanne mit schrägstehenden oder parabelartigen Seitenwänden aufweist, in der das Halbleiterbauelement derart montiert ist, dass die Fensterschicht zum Reflektorwannenboden hin gerichtet ist.
60. Strahlungsemittierendes optisches Bauelement nach Aspekt 59, wobei die Seitenwände der Reflektorwanne mit reflexionssteigerndem Material beschichtet sind.
61. Strahlungsemittierendes optisches Bauelement nach Aspekt 59 oder 60, wobei die Seitenwände der Reflektorwanne so ausgebildet sind, daß die vom Halbleiterbauelement nach rückwärts ausgesandte Strahlung von den schrägen Seitenwänden weitestgehend in ein und derselben Richtung zur aktiven Schicht nach oben reflektiert wird.

Weitere Merkmale, Vorzüge und Zweckmäßigkeiten der Erfindung werden nachfolgend anhand von Ausführungsbeispielen in Verbindung mit den Figuren 1 bis 16 erläutert.

Es zeigen:
Figur 1 eine schematische Schnittdarstellung eines ersten Ausführungsbeispiels eines erfindungsgemäßen Halbleiterbauelementes,
Figur 2 eine schematische Schnittdarstellung eines zweiten Ausführungsbeispieles eines erfindungsgemäßen Halbleiterbauelementes,
Figur 3 eine schematische Schnittdarstellung eines dritten Ausführungsbeispieles eines erfindungsgemäßen Halbleiterbauelementes
Figur 4 eine schematische Schnittdarstellung eines vierten Ausführungsbeispieles eines erfindungsgemäßen Halbleiterbauelementes
Figur 5 eine schematische Schnittdarstellung eines fünften Ausführungsbeispieles eines erfindungsgemäßen Halbleiterbauelementes
Figur 6 eine schematische Schnittdarstellung eines sechsten Ausführungsbeispieles eines erfindungsgemäßen Halbleiterbauelementes
Figur 7 eine schematische Schnittdarstellung eines siebten Ausführungsbeispieles eines erfindungsgemäßen Halbleiterbauelementes
Figur 8 eine schematische Schnittdarstellung eines achten Ausführungsbeispieles eines erfindungsgemäßen Halbleiterbauelementes
Figur 9 eine schematische Schnittdarstellung eines neuten Ausführungsbeispieles eines erfindungsgemäßen Halbleiterbauelementes
Figur 10 eine schematische Schnittdarstellung eines zehnten Ausführungsbeispieles eines erfindungsgemäßen Halbleiterbauelementes
Figur 11 eine schematische Schnittdarstellung eines elften Ausführungsbeispieles eines erfindungsgemäßen Halbleiterbauelementes
Figur 12 eine schematische perspektivische Darstellung eines zwölften Ausführungsbeispiels eines erfindungsgemäßen Halbleiterbauelements,
Figur 13 eine schematische Darstellung eines dreizehnten Ausführungsbeispiels eines erfindungsgemäßen Halbleiterbauelements,
Figur 14 eine schematische Darstellung eines ersten Ausführungsbeispiels eines erfindungsgemäßen Herstellungsverfahrens in fünf Zwischenschritten,
Figur 15 eine schematische Darstellung eines zweiten Ausführungsbeispiels eines erfindungsgemäßen Herstellungsverfahrens in sechs Zwischenschritten,
Figur 16 eine Vorrichtung zur Durchführung eines Zwischenschrittes bei den Ausführungsbeispielen eines erfindungsgemäßen Herstellungsverfahrens und
Figur 17 eine schematische Darstellung eines strahlungsemittierenden Halbleiterbauelementes nach dem Stand der Technik.

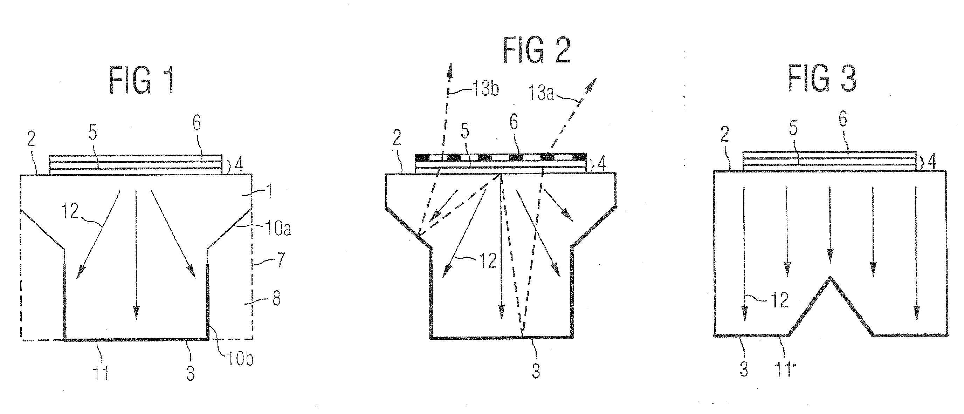

Das in Figur 1 gezeigte Ausführungsbeispiel weist ein Fenster 1 mit einer ersten Hauptfläche 2 und einer zweiten Hauptfläche 3 auf. Auf die erste Hauptfläche 2 ist eine Mehrschichtstruktur 4 mit einer aktiven, im Betrieb strahlungsemittierenden Schicht 5 aufgebracht, die von einer Kontaktmetallisierung 6 bedeckt wird.

Das Fenster 1 selbst ist aus einer quaderförmigen, im Schnitt rechteckigen Grundform 7 gebildet, die umfangsseitig Ausnehmungen 8 aufweist. Die so entstehenden Fensterflanken 10 entsprechen auch den Seitenflächen der Ausnehmung und weisen einen ersten Teilbereich 10 a auf, der schräg zu den Hauptflächen 2, 3 des Fensters angeordnet ist und der in größerer Entfernung von der Mehrschichtstruktur 4 in einen zweiten, zu den Hauptflächen orthogonalen Teilbereich 10 b übergeht.

In diesem zweiten Teilbereich 10 b sind die Fensterflanken mit einer Kontaktmetallisierung 11 versehen, die auch die zweite Hauptfläche 3 des Fensters 1 bedeckt. Durch die an der Fensterflanke 10 b hochgezogene Kontaktfläche 11 werden die Stromwege 12 von der aktiven Schicht zur Kontaktfläche 11 im Mittel verkürzt und somit der Serienwiderstand des Bauelementes vorteilhaft gesenkt. Die Auskopplung der Strahlung erfolg vorzugsweise im angeschrägten Bereich 10 a der Fensterflanken.

Bei dem in Figur 2 gezeigten Ausführungsbeispiel erstreckt sich die Kontaktmetallisierung 11 bis über die angeschrägten Teilbereiche 10 a der Fensterflanken. Damit wird eine weitere Verkürzung der Stromwege 12 und somit eine Reduktion des Serienwiderstands erreicht. Allerdings stehen nun die Teilbereiche 10 a nicht mehr für eine direkte Strahlungsauskopplung zur Verfügung. Daher ist bei diesem Ausführungsbeispiel die Kontaktmetallisierung 11 spiegelnd ausgeformt, so daß die in das Fenster emittierten Strahlungsanteile größtenteils wieder in Richtung der Mehrschichtstruktur 4 reflektiert und nachfolgend ausgekoppelt werden. Dies ist exemplarisch anhand der Strahlen 13 a und 13 b verdeutlicht. Alternativ können die entsprechenden Kontaktflächen auch perforiert werden.

Bei dem in Figur 3 dargestellten dritten Ausführungsbeispiel verläuft im Unterschied zu den vorangehend beschriebenen Ausführungsbeispielen die Ausnehmung 8 als zentrale Vertiefung durch das Zentrum der zweiten Hauptfläche 3. Die Kontaktmetallisierung 11 ist vollflächig über die zweite Hauptfläche 3 und die Seitenflächen der Vertiefung 8 ausgebildet. Innerhalb der Vertiefung 8 wird so der Stromweg 12 zur aktiven Schicht verkürzt und der Serienwiderstand des Bauelementes reduziert. Zur Erhöhung der Strahlungsausbeute kann die Kontaktmetallisierung wieder spiegelnd gebildet sein.

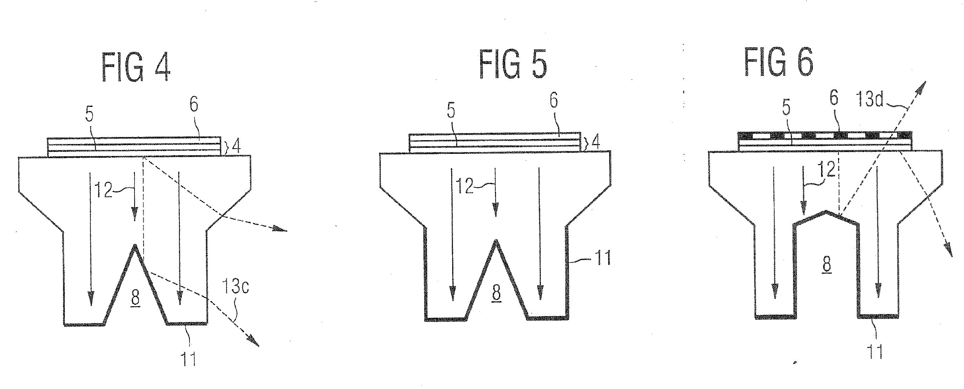

In Figur 4 ist ein viertes Ausführungsbeispiel gezeigt, bei dem die einhüllende des ersten Ausführungsbeispiels vorteilhaft mit der zentralen Vertiefung des dritten Ausführungsbeispiels kombiniert ist. Mit Vorteil wird so der Serienwiderstand durch die Verkürzung der Stromwege 12 wie bei dem dritten Ausführungsbeispiel gesenkt, wobei zugleich die gesamte Fensterflanke zur Auskopplung der Strahlung zur Verfügung steht. Zusätzlich wird aufgrund der zentralen Vertiefung 8 mit spiegelnder Kontaktmetallisierung 11 die Strahlungsausbeute durch die seitlich herausreflektierten Strahlungsanteile 13 erhöht.

Bei dem in Figur 5 dargestellten fünften Ausführungsbeispiel erstreckt sich die Kontaktmetallisierung 11 sowohl über die zentrale Vertiefung 8 in der zweiten Hauptfläche des Fensters 1 wie auch über Teilbereiche der Fensterflanken 10. Gegenüber dem vierten Ausführungsbeispiel wird so der Serienwiderstand weiter gesenkt, wobei dies eine verminderte Strahlungsausbeute im Bereich der Kontaktmetallisierung mit sich bringt. Je nach Gewichtung der Parameter Serienwiderstand und Strahlungsausbeute kann das vierte oder das fünfte Ausführungsbeispiel vorteilhafter sein, wobei der Übergang zwischen diesen Ausführungsbeispielen je nach Umfang der Kontaktmetallisierung auf den Fensterflanken fließend ist.

Die Erhöhung der Strahlungsausbeute durch Reflexion an der zentralen Vertiefung 8 in der zweiten Hauptfläche 3 kann auf verschiedene Art und Weise stattfinden. Eine Möglichkeit wurde bereits im Rahmen des vierten Ausführungsbeispieles in Figur 4, Strahl 13 c gezeigt. Wird der Scheitelwinkel der zentralen Vertiefung 8 vergrößert, so hat dies eine vermehrte Reflexion in Richtung der Mehrschichtstruktur 4 und somit eine Auskopplung durch die Mehrschichtstruktur 4 zur Folge.

Dies ist in dem sechsten Ausführungsbeispiel in Figur 6 anhand des Strahles 13 d schematisch dargestellt. Abgesehen von der zentralen Vertiefung 8 entspricht dieses Ausführungsbeispiel dem vierten Ausführungsbeispiel, Figur 4. Die zentrale Vertiefung 8 hingegen ist deutlich tiefer als in Figur 4 eingeschnitten und weist einen fünfeckigen Querschnitt auf, der sich aus einem Rechteck mit angefügtem Dreieck zusammensetzt. Der Scheitelwinkel des Dreieckes ist dabei größer als bei dem in Figur 4 dargestellten Ausführungsbeispiel und bewirkt eine vermehrte Reflexion in Richtung der Mehrschichtstruktur 4. Hierbei ist es vorteihaft, die Kontaktfläche 6 auf der Mehrschichtstruktur perforiert auszubilden und so den Auskopplung durch diese Kontaktfläche zu vergrößern.

Die tief eingeschnittene und vollständig metallisierte Ausnehmung 8 führt zudem aufgrund der Nähe der Bodenfläche der Ausnehmung zur Mehrschichtstruktur 4 zu einer besonders großen Verkürzung der Stromwege 12.

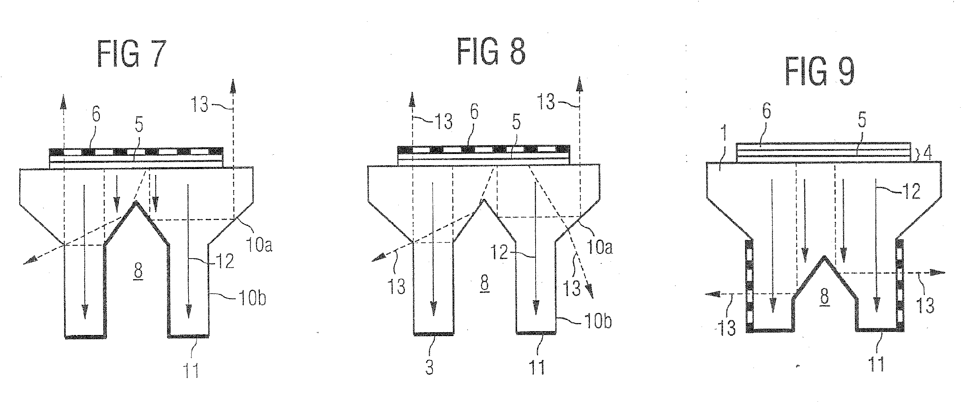

Bei dem in Figur 7 dargestellten siebten Ausführungsbeispiel ist im Unterschied zu dem sechsten Ausführungsbeispiel der Scheitelwinkel der zentralen Ausnehmung kleiner gewählt. Die führt zu einer vermehrten Reflexion in Richtung der schräggestellten Fensterseitenflächenteile 10a und in Verbindung damit zu einer erhöhten Auskopplung auf seiten der Mehrschichtstruktur 4. Auch hier ist es vorteilhaft, die Kontaktfläche 6 auf der Mehrschichtstruktur 4 perforiert auszubilden. Verschiedene Strahlwege sind schematisch anhand der Strahlen 13 dargestellt.

Bei dem in Figur 8 gezeigten achten Ausführungsbeispiel ist im Unterschied zu den bisherigen Ausführungsbeispielen nur die zweite Hauptfläche 3 und die Mehrschichtstruktur 4 mit Kontaktflächen versehen, wobei die Kontaktfläche 6 auf der Mehrschichtstruktur perforiert ausgebildet ist. Damit wird eine besonders hohe Strahlungsauskopplung über die Seitenflächen 10 erreicht. Die zentrale Vertiefung 8 ist so gebildet, daß an einem Teil ihrer Seitenflächen totalreflektiert wird.

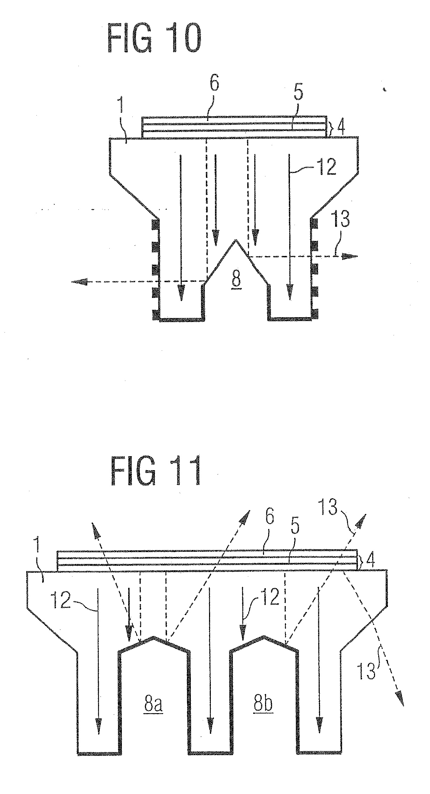

Bei den in Figur 9 und 10 gezeigten Ausführungsbeispielen sind die Seitenflächen des Fensters teilweise mit perforierten Kontaktflächen versehen. Damit ist auch in den Bereichen dieser Kontaktflächen mit Vorteil eine Strahlungsauskopplung möglich, wobei durch die Verringerung des Abstands zwischen den Kontaktflächen 6 und 11 der Serienwiderstand vorteilhaft verringert ist. Bei dem in Figur 9 gezeigten Ausführungsbeispiel erstreckt sich die Kontaktfläche auch über die zentrale Ausnehmung 8. Bei dem Ausführungsbeispiel nach Figur 10 hingegen ist zur Verringerung des Herstellungsaufwands die zentrale Ausnehmung unbedeckt, die Strahlung 13 wird an der Innenseite der zentralen Ausnehmung 8 totalreflektiert.

In Figur 11 ist ein weiteres Ausführungsbeispiel dargestellt, das im Unterschied zu den bisher beschriebenen Ausführungsbeispielen zwei zentrale Vertiefungen 8 a, b aufweist. Die Ausnehmungen 8 a, b und die darauf ausgebildete Kontaktmetallisierung 11 entspricht in ihrer Form dem sechsten Ausführungsbeispiel, wobei selbstverständlich eine Kombination mit den anderen gezeigten Ausführungsbeispielen ebenfalls möglich ist. Die mehrfache Anordnung von Vertiefungen in der zweiten Hauptfläche 3 ist insbesondere für großflächige Halbleiterbauelemente vorteilhaft, da mit einer Mehrzahl von Ausnehmungen sowohl der Serienwiderstand des Bauelementes als auch die Strahlungsausbeute über die gesamte Bauelementfläche gesenkt bzw. erhöht werden kann. Soweit es die Stabilität des Bauelementes zuläßt, können selbstverständlich auch mehr als die gezeigten zwei Vertiefungen 8a,b gebildet werden.

Vorzugsweise besteht bei den Ausführungsbeispielen das Fenster 1 aus Siliciumcarbid, auf das eine Galliumnitrid-basierende Mehrschichtstruktur aufgebracht ist. Siliciumcarbid wird bevorzugt als Epitaxiesubstrat für Galliumnitrit-basierende Halbleiterbauelemente verwendet. Unter Galliumnitrid-basierenden Materialien sind dabei neben GaN selbst von GaN abgeleitete oder damit verwandte Materialien, insbesondere ternäre oder quaternäre Mischkristallsysteme wie AlGaN (Al₁-ₓGaₓN, 0≤x≤1), InGaN (In₁₋ₓGaₓN, 0≤x≤1), InAlN (In₁₋ₓAlₓN, 0≤x≤1) und AlInGaN (Al_{1-x-y}InₓGa_{y}N, 0≤x≤1, 0≤y≤1) zu verstehen.

Die epitaktische Herstellung solcher Galliumnitrid-basierender Bauelemente erfordert ein weitgehend an Galliumnitrid-Gitter angepaßtes Substrat, wofür sich Siliciumcarbid besonders eignet.

Allerdings weist Siliciumcarbid einen sehr hohen Brechungsindex von etwa 2,7 auf, so daß die Totalreflexionsverluste entsprechend hoch bzw. der Auskoppelgrad entsprechend gering ist. Die gezeigten Ausführungsbeispiele erhöhen insbesondere aufgrund der angeschrägten Seitenflächen mit Vorteil die Strahlungsausbeute. Der durch den reduzierten Querschnitt des Fensters prinzipiell vergrößerte serielle Widerstand des Bauelementes wird bei der Erfindung vorteilhafterweise durch die seitlich hochgezogenen Kontaktflächen kompensiert bzw. sogar darüberhinaus erniedrigt. Die Ausbildung spiegelnder, semitransparenter oder perforierter Kontaktmetallisierungen trägt zu einer weiteren Erhöhung der Strahlungsausbeute bei.

Die Erfindung ist jedoch nicht auf Galliumnitrid-basierende Systeme beschränkt, sondern kann ebenso bei anderen Halbleitersystemen, wie beispielsweise Galliumarsenid-, Galliumphosphid oder Zinkselenid-basierenden Materialien angewandt werden. Auch hier verbleibt ein erheblicher Teil der erzeugten Strahlung aufgrund von Totalreflexion in der Mehrschichtstruktur-Fenster-Anordnung und wird schließlich absorbiert.

Ebenso ist die Erfindung auch für andere als die bisher genannten Fenstermaterialien, beispielsweise Quarzglas, Diamant, ITO (Indium tin oxide) oder auf Zinkoxid, Zinnoxid, Indiumoxid oder Galliumphosphid-basierende Materialien vorteilhaft, da in der Regel bei all diesen Fenstern bei der Auskopplung ein Übergang in ein optisch dünneres Medium vorliegt, bei dem Totalreflexion auftreten kann und der Auskoppelgrad dementsprechend reduziert ist.

Weiterhin ist die Erfindung auch für vergossene oder anderweitig mit einer Umhüllung versehene Halbleiterkörper bzw. Fenster vorteilhaft, da die Umhüllung in der Regel einen niedrigeren Brechungsindex aufweist, so daß auch in diesem Fall die Strahlungsausbeute durch Totalreflexion vermindert wird.

Ein Fenster aus den genannten Materialien kann nach der Herstellung der Mehrschichtstruktur auf die Mehrschichtstruktur aufgebracht werden. Bei einer epitaktischen Herstellung der Mehrschichtstruktur ist dies beispielsweise dadurch möglich, daß nach der Epitaxie das Epitaxiesubstrat abgelöst und das Fenster an dessen Stelle mittels eines Waverbonding-Verfahrens mit der Mehrschichtstruktur verbunden wird.

Alternativ kann das Fenster auch auf die epitaktisch hergestellte Halbleiteroberfläche aufgebracht und danach das Epitaxiesubstrat abgelöst werden. Diese Vorgehensweise besitzt den Vorteil, daß das Epitaxiesubstrat weiter verwendet werden kann, was insbesondere bei teuren Materialien hier beispielsweise Siliciumcarbid-Substraten zu einem deutlichen Kostenvorteil führt.

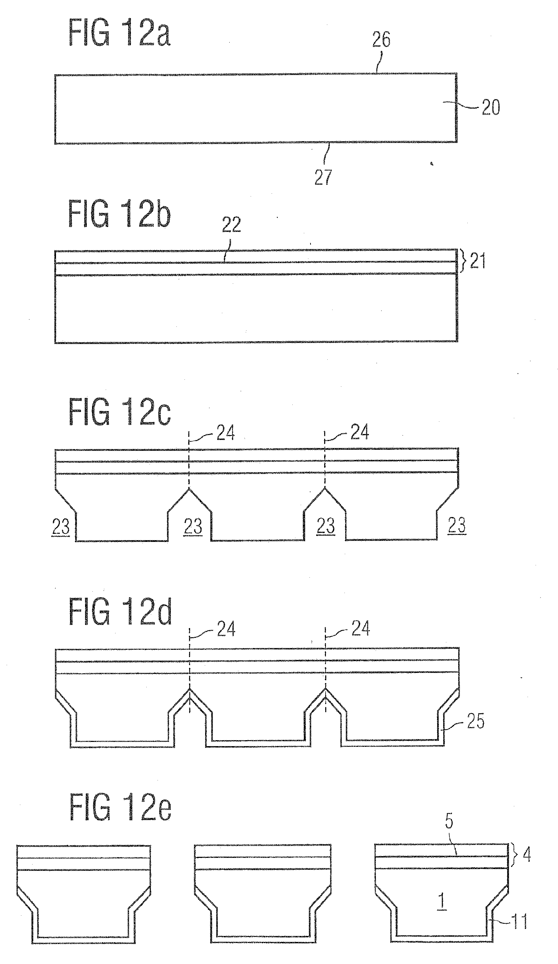

In Figur 12 ist anhand von fünf Zwischenschritten 12 a bis 12 c ein erstes Ausführungsbeispiel eines erfindungsgemäßen Herstellungsverfahrens schematisch dargestellt.

Zunächst wird eine Fensterschicht 20, aus der später das Fenster 1 gefertigt wird, bereitgestellt, Figur 12 a. Die Fensterschicht 20 kann beispielsweise in Form eines Siliciumcarbid-Substrates vorliegen.

Auf die Fensterschicht 20 wird eine Halbleiterschichtenfolge 21 aufgebracht, die insbesondere eine aktive, im Betrieb strahlungserzeugende Halbleiterschicht enthält. Die Halbleiterschichtenfolge 21 entspricht dabei der Mehrschichtstruktur 4 eines erfindungsgemäßen Halbleiterbauelementes. Die Schichtenfolge wird vorzugsweise epitaktisch aufgewachsen oder mittels eines Waferbonding-Verfahrens aufgebracht. Ein Epitaxieverfahren reduziert vorteilhafterweise die Anzahl der Herstellungsschritte, da mit der epitaktischen Herstellung der Halbleiterschichtenfolge 21 auch bereits die Aufbringung auf die Fensterschicht 20 erfolgt. Ein Waferbonding-Verfahren hingegen besitzt den Vorteil, daß auch zur Epitaxie ungeeignete, aber ansonsten vorteilhafte Materialien für die Fensterschicht verwendet werden können. Zudem können die bei der Herstellung der Halbleiterschichtenfolge verwendeten Epitaxiesubstrate weiterverwendet und so die Herstellungskosten reduziert werden.

Nach der Aufbringung der Halbleiterschichtenfolge 21 wird die Fensterschicht 20 strukturiert, Figur 12 b. Bei dem gezeigten Ausführungsbeispiel wird dazu die Fensterschicht 12 an den für die spätere Vereinzelung vorgesehenen Trennungsstellen 24 eingesägt. Das Sägeblatt weist einen Formrand auf, der im Sägebereich im Querschnitt zu der zu bildenden Ausnehmung 23 komplimentär ist. Zur Ausbildung einer zentralen Vertiefung, wie sie beispielsweise bei dem dritten Ausführungsbeispiel dargestellt ist, müßte lediglich der Sägeschnitt zwischen den Trennungsstellen 24 erfolgen.

Nachfolgend wird auf der strukturierten Fensterschicht 20 eine durchgehende Kontaktmetallisierung 25 ausgebildet. Dieser Schritt wird nachfolgend genauer erläutert.

Abschließend wird der Verbund aus Halbleiterschichtenfolgen 21 und Fensterschicht 20 durch Brechen an den Trennungsstellen 24 in einzelne Halbleiterbauelemente vereinzelt, wobei die Teile der Fensterschicht 20 das Fenster 1 und die darauf aufgebrachten Teile der Halbleiterschichtenfolge 21 die Mehrschichtstruktur 4 bilden.

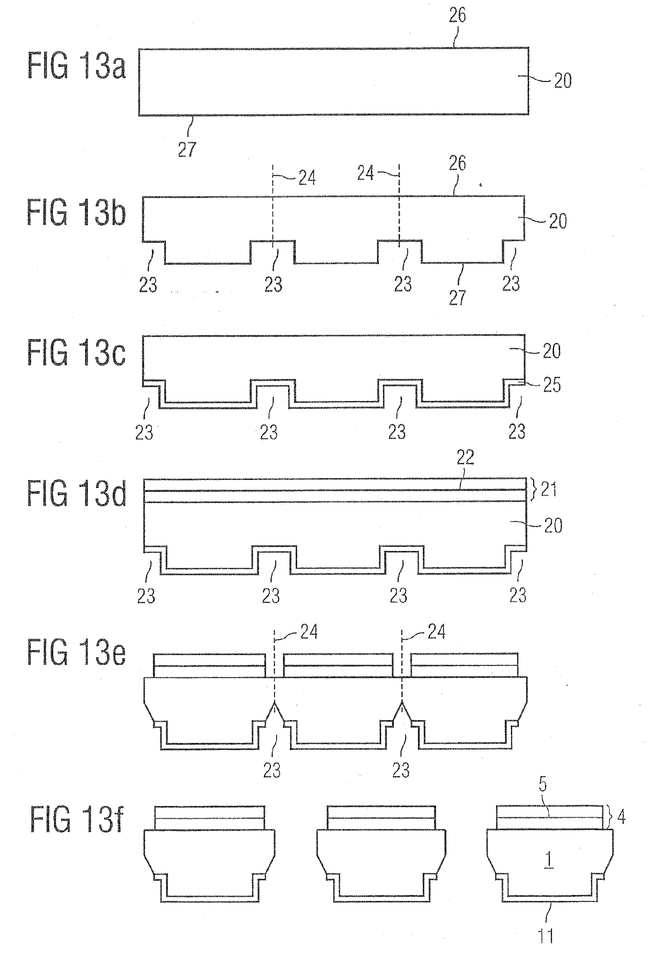

In Figur 13 ist ein zweites Ausführungsbeispiel eines erfindungsgemäßen Herstellungsverfahrens gezeigt. Wiederum beginnt das Verfahren mit der Bereitstellung einer Fensterschicht 20, Figur 13 a. Die Fensterschicht 20 weist eine erste Hauptfläche 26 auf, die zur Aufbringung einer Halbleiterschichtenfolge vorgesehen ist. Auf der zweiten Hauptfläche 27 der Fensterschicht erfolgt die Strukturierung.

Nachfolgend wird die Fensterschicht 20 vor der Aufbringung der Halbleiterschichtenfolge 21 vorstrukturiert, Figur 13 b. Dazu wird an den vorgesehenen Trennungsstellen 24 die Fensterschicht 20 auf der zweiten Hauptfläche 27 eingesägt, so daß eine Mehrzahl von Ausnehmungen 23 mit beispielsweise rechteckigem Querschnitt entsteht. Die Sägetiefe bzw. die Tiefe der Ausnehmungen 23 ist so gewählt, daß gerade die mit einer Kontaktfläche zu versehenden Seitenflächen freiliegen. Eine weitergehende, tiefere Strukturierung erfolgt erst in einem späteren Schritt des Herstellungsverfahrens, so daß die mechanische Stabilität der Fensterschicht zunächst weitgehend erhalten bleibt.

Die so gebildeten Ausnehmungen 23 und die verbleibenden Bereiche der zweiten Hauptfläche 27 werden nun mit einer durchgehenden Kontaktmetallisierung 25 versehen. Da sich auf der Fensterschicht 20 noch keine Halbleiterschichten befinden, kann die Kontaktmetallisierung 25 vorteilhafterweise bei wesentlich höheren Temperaturen als im vorigen Ausführungsbeispiel ausgebildet werden. Dies vereinfacht bzw. ermöglicht beispielsweise eine Sinterung der Kontaktmetallisierung, die ebenfalls den Serienwiderstand des Bauelementes vorteilhaft senkt.

Im folgenden Schritt wird wie im zuvor beschriebenen Ausführungsbeispiel eine Halbleiterschichtenfolge 21, die eine aktive Schicht 24 enthält, auf die erste Hauptfläche 26 der Fensterschicht 20 aufgebracht. Da die Kontaktmetallisierung 25 bereits ausgebildet ist, können insbesondere auch empfindliche Halbleiterstrukturen wie beispielsweise Mehrfachquantentop-Strukturen mit geringen Strukturdicken, die bei höheren Temperaturen leicht degradieren, gebildet werden.

Es folgt darauf ein weiterer Strukturierungsschritt, bei dem die bereits begonnene Strukturierung der Fensterschicht 20 vollendet wird. Hierbei werden die bereits gebildeten Ausnehmungen 23 durch nochmaliges Einsägen vertieft und weiter geformt, beispielsweise durch Ausbildung schräger Flanken in der Fensterschicht zur Erhöhung der Strahlungsauskopplung. Zudem wird auch die Halbleiterschichtenfolge 21 in einzelne Mehrschichtstrukturen 4 aufgeteilt. Zur Strukturierung der Halbleiterschichtenfolge 21 eignet sich beispielsweise ein Ätzverfahren unter Verwendung einer bekannten Maskentechnik.

Im letzten Schritt, Figur 13 f, wird der Verbund aus Fensterschichten und Mehrschichtstruktur wie im vorangegangenen Ausführungsbeispiel vereinzelt.

Bei dem beschriebenen Herstellungsverfahren ist es erforderlich, strukturierte Flächen, wie beispielsweise die Fläche 27 und die darin gebildeten Ausnehmungen 23 in Figur 12, mit einer einheitlichen Kontaktfläche zu versehen. Diese strukturierten Flächen setzen sich aus einer Mehrzahl gewinkelt verbundener Einzelflächen zusammen, wodurch die Ausbildung einer Kontaktfläche erschwert wird. Eine geeignete Vorrichtung zum Aufbringen einer Kontaktmetallisierung ist in Figur 14 gezeigt. Die Vorrichtung enthält eine Metalldampfquelle 30, aus der Metalldampf 32 mit einer Vorzugsrichtung austritt. Als Metalldampfquelle 30 kann beispielsweise ein Elektronenstrahlverdampfer mit einem Target und einem auf dieses Target gerichteten Elektronenstrahl verwendet werden.

Eine Fensterschicht 20 ist mit der zu bedampfenden Fläche der Dampfquelle 30 zugewandt, wobei die zu bedampfende Fläche schräg zur Vorzugsrichtung der Metalldampfquelle 32 angeordnet ist. Damit schlägt sich der Metalldampf 32 sowohl auf der Hauptfläche 27 als auch auf den Innenseiten der Ausnehmungen 23 nieder. Der bedampfte Bereich innerhalb der Ausnehmungen wird im wesentlichen durch Abschattungen vorspringender Kanten bestimmt. Je nach Neigung der zu bedampfenden Fläche gegen die Vorzugsrichtung der Bedampfungsquelle variiert so die Tiefe, bis zu der die Metallschicht innerhalb der Ausnehmungen 23 ausgebildet wird.

In Figur 15 ist perspektivisch ein weiteres Ausführungsbeispiel der Erfindung gezeigt, wobei das Fenster zu Erhöhung der Strahlungsauskopplung Fensterflanken mit einem schäggestellten Bereich 10a aufweisen. Weiterhin ist die Mehrschichtstruktur 4 mit einer perforierten Kotaktfläche 6 versehen, die eine Mehrzahl kreisförmiger Öffnungen 14 aufweist. Die Kontaktfläche selbst kann beispielsweise als dicke, spiegelnde Platin oder Palladiumkontaktschicht ausgebildet sein, wobei die Dicke vorzugsweise zwsichen 10nm und 30nm liegt.

Alternativ kann die Kontaktschicht 6 auch dünner geformt sein, so daß die Kontaktschicht 6 strahlungsdurchlässig ist. Mit Vorteil wird dann die erzeugte Strahlung sowohl durch die Öffnungen 14 als auch durch die Kontaktschicht hindurch ausgekoppelt.

In Figur 16 sind zwei Aufsichten auf ein Ausführungsbeispiel der Erfindung mit perforierter Kontaktfläche gezeigt. Bei dem in figur 16 a dargestellten Ausführungsbeispiel sind die Öffnungen in der Kontaktschicht 6 kreisförmig gebildet. Alternativ können die Öffnungen auch beispielsweise kreuzschlitzartig gebildet sein, wie Figur 16b zeigt. Bevorzugt sind die Öffnungen dicht gepackt angeordnet. Damit die dazwischenliegenden Kontaktflächenbereiche nicht zu schmal werden und damit die Stromeinleitung in das Bauelement verschlechtern, sind die kreuzschlitzartigen Öffungen in Figur 16b so angeordnet, daß ihr gegenseitger Abstand nicht geringer ist als die Stegbreite a.

Der Durchmesser bzw. die Stegbreite a der Öffnungen 14 ist vorteilhafterweise so bemessen, daß sich durch die Stromaufweitung eine weitgehend homogene Stromdichte in der aktiven Schicht ergibt.

Die Erläuterung der Erfindung anhand der gezeigten Ausführungsbeispiele stellt selbstverständlich keine Beschränkung der Erfindung auf diese Ausführungsbeispiele dar.

## Patentansprüche

1. Strahlungsemittierendes Halbleiterbauelement mit einer Mehrschichtstruktur (4), die eine strahlungsemittierende, aktive Schicht (5) enthält, und einem strahlungsdurchlässigen Fenster (1), das eine erste Hauptfläche (2) und eine der ersten Hauptfläche gegenüberliegende zweite Hauptfläche (3) aufweist und das mit der ersten Hauptfläche (2) an die Mehrschichtstruktur (4) grenzt, wobei das Fenster (1) zur Bildung von schräg zur ersten Hauptfläche (2) verlaufenden Strahlungsauskoppelflächen zumindest eine Ausnehmung (8) aufweist, **dadurch gekennzeichnet, dass**
die Mehrschichtstruktur (4) zumindst teilweise mit einer Kontaktfläche (6) versehen ist, die eine Mehrzahl von Öffnungen (14) aufweist.

2. Strahlungsemittierendes Halbleiterbauelement nach Anspruch 1,
**dadurch gekennzeichnet, dass**
die zweite Hauptfläche (3) und/oder mindestens eine an die zweite Hauptfläche (3) grenzende Seitenfläche des Fensters und/oder der Ausnehmung zumindest teilweise mit einer weiteren Kontaktfläche (11) versehen ist.

3. Strahlungsemittierendes Halbleiterbauelement nach Anspruch 2,
**dadurch gekennzeichnet, dass**
die weitere Kontaktfläche (11) eine Mehrzahl von Öffnungen aufweist.

4. Strahlungsemittierendes Halbleiterbauelement nach einem der obigen Ansprüche,
**dadurch gekennzeichnet, dass**
das Fenster (1) aus dem für das Aufwachsen der Mehrschichtstruktur (4) genutzten Aufwachssubstrat gefertigt ist.

5. Strahlungsemittierendes Halbleiterbauelement nach einem der obigen Ansprüche,
**dadurch gekennzeichnet, dass**
der Brechungsindex des Materials des Fensters (1) größer als der Brechungsindex des Materials der Mehrschichtstruktur (4), insbesondere der aktiven Schicht (5) ist.

6. Strahlungsemittierendes Halbleiterbauelement nach einem der obigen Ansprüche,
**dadurch gekennzeichnet, dass**
das Fenster (1) aus Siliciumcarbid besteht oder auf Siliciumcarbid basiert und die Mehrschichtfolge (4) aus Nitrid-basierenden Halbleitermaterialien gefertigt ist.

7. Strahlungsemittierendes Halbleiterbauelement nach einem der obigen Ansprüche,
**dadurch gekennzeichnet, dass**
die Öffnungen (14) kreisförmig, quadratisch, rechteckig, sechseckig oder kreuzschlitzförmig gebildet sind.

8. Strahlungsemittierendes Halbleiterbauelement nach einem der obigen Ansprüche,
**dadurch gekennzeichnet, dass**
die Öffnungen (14) zumindest in Teilbereichen der Kontaktflächen (6) regelmäßig angeordnet sind.

9. Strahlungsemittierendes Halbleiterbauelement nach einem der obigen Ansprüche,
**dadurch gekennzeichnet, dass**
die Kontaktfläche (6) als spiegelnde Kontaktmetallisierung ausgebildet ist.

10. Strahlungsemittierendes Halbleiterbauelement nach einem der obigen Ansprüche,
**dadurch gekennzeichnet, dass**
die Kontaktfläche (6) strahlungsdurchlässig ausgebildet ist.

11. Strahlungsemittierendes Halbleiterbauelement nach einem der obigen Ansprüche,
**dadurch gekennzeichnet, dass**
die Kontaktflächen(6,11) Silber, Gold, Nickel, bevorzugt Platin oder Palladium, oder eine Legierungen dieser Metalle enthält.

12. Strahlungsemittierendes Halbleiterbauelement nach einem der obigen Ansprüche,
**dadurch gekennzeichnet, dass** die Kontaktflächen (6) eine Dicke zwischen 5nm und 200nm, vorzugsweise zwischen 10nm und 100nm aufweist.

13. Strahlungsemittierendes optisches Bauelement mit einem strahlungsemittierenden Halbleiterbauelement nach einem der obigen Ansprüche,
**dadurch gekennzeichnet, dass**
das optische Bauelement eine Reflektorwanne mit schrägstehenden oder parabelartigen Seitenwänden aufweist, in der das Halbleiterbauelement derart montiert ist, dass die Fensterschicht zum Reflektorwannenboden hin gerichtet ist.

14. Strahlungsemittierendes optisches Bauelement nach dem vorherigen Anspruch,
**dadurch gekennzeichnet, dass**
die Seitenwände der Reflektorwanne mit reflexionssteigerndem Material beschichtet sind.

15. Strahlungsemittierendes optisches Bauelement nach Anspruch 13 oder 14,
**dadurch gekennzeichnet, dass**
die Seitenwände der Reflektorwanne so ausgebildet sind, daß die vom Halbleiterbauelement nach rückwärts ausgesandte Strahlung von den schrägen Seitenwänden weitestgehend in ein und derselben Richtung zur aktiven Schicht nach oben reflektiert wird.
